# FASCICULE DE BREVET EUROPEEN

(11) **EP 3 240 030 B1**
(45) Date de publication et mention de la délivrance du brevet: **18.08.2021**
(21) Numéro de dépôt: 17167630.7
(22) Date de dépôt: 21.04.2017
(51) Int. Cl.: H01L 27/144, H01L 27/146, H01L 31/0296, H01L 31/103, H01L 31/18

(54) **DISPOSITIF DE PHOTO-DÉTECTION À RÉSEAU INTER-DIODES SUR-DOPÉ ET PROCÉDÉ DE FABRICATION**
PHOTODETEKTORGERÄT MIT HOCHDOTIERTEM INTERDIODEN-NETZ, UND SEIN HERSTELLUNGSVERFAHREN
PHOTO-DETECTION DEVICE WITH OVERDOPED INTER-DIODE ARRAY AND MANUFACTURING METHOD

(30) Priorité: 26.04.2016 FR 1653666
(43) Date de publication de la demande: 01.11.2017
(73) Titulaire: Commissariat à l'énergie atomique et aux énergies alternatives, 75015 Paris (FR)
(72) Inventeur: ROTHMAN, Johan, 38000 GRENOBLE (FR)
(74) Mandataire: Brevalex

(56) Documents cités:
- EP-A1- 0 350 351
- EP-A1- 3 381 057
- FR-A1- 2 983 347
- JP-A- S62 119 976

## Description

### DOMAINE TECHNIQUE

Le domaine de l'invention est celui des photo-détecteurs comprenant un réseau de diodes, tel qu'un réseau matriciel, fabriquées sur un substrat semi-conducteur. L'invention a trait plus précisément aux diodes de type p/n ou n/p qui peuvent être utilisées pour des imageurs dans le visible ou dans l'infrarouge.

### ÉTAT DE LA TECHNIQUE ANTÉRIEURE

Dans de nombreuses applications de photo-détection, des diodes sont agencées en matrices de diodes sur un substrat. Dans une matrice, les diodes sont agencées en lignes et en colonnes. Une matrice de diode peut être utilisée pour permettre une détection d'un rayonnement électromagnétique. Il peut en effet se former des paires électrons-trous par interaction entre le rayonnement électromagnétique et le substrat. Cela permet l'apparition d'un courant proportionnel à une intensité du rayonnement incident. Chaque diode forme alors un pixel d'un photo-détecteur.

En venant coupler la matrice de diodes avec un circuit électronique de lecture, il est ainsi possible de capter la variation spatio-temporelle de l'intensité de lumière sur le photo-détecteur. La sensibilité d'un tel photo-détecteur est donnée par sa capacité à traduire des faibles variations spatiales ou temporelles de l'intensité de lumière en un signal comparé utilisable malgré des variations aléatoires (bruit) résultant de phénomènes thermiques et électriques dans les diodes et dans le circuit de lecture.

Une telle matrice de diodes est illustrée sur les figures la et 1b qui représentent respectivement une vue de dessus et une vue en coupe, selon le plan de coupe référencé 1b sur la figure la, le long d'une ligne de la matrice. Une diode est formée dans un substrat présentant une couche d'absorption 1 en un matériau semi-conducteur avec une largeur de gap interdit et caractérisé par un type de conductivité. La diode comprend une région de collection 2 de type de conductivité opposé, formant ainsi une jonction p-n.

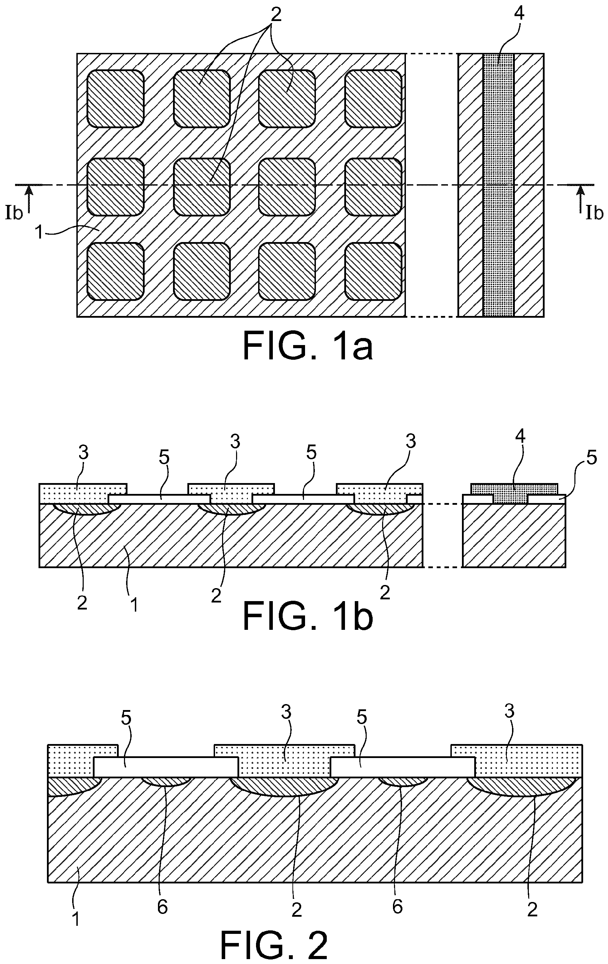

Comme illustré sur la figure 1b, chaque région de collection est en contact avec un plot métallique 3 formant un contact diode. Une région métallique 4, formée en périphérie de la matrice, est en contact avec le substrat, et forme un contact substrat. Les deux régions de type de conductivité opposé 1, 2 sont protégées d'une dégradation de leurs propriétés chimiques, mécaniques et électroniques au moyen d'une couche de passivation 5 recouvrant la surface du substrat à l'exception des zones de contact diode et de contact substrat.

Dans la région à proximité de l'interface des deux régions de type de conductivité opposé 1, 2 se forme une zone dite de charge espace (ZCE). Cette zone est caractérisée par la présence d'une barrière d'énergie pour les porteurs majoritaires de chaque côté de la jonction. Les photons arrivant dans la couche d'absorption 1 du substrat semi-conducteur peuvent céder leur énergie à un électron. Si l'électron transite entre la bande de valence et la bande de conduction et se déplace jusqu'à la zone de charge d'espace, la charge va être collectée par la région de collection 2. Les charges ainsi collectées peuvent être transférées à un circuit électronique, appelé circuit de lecture, connecté à chaque diode pour disposer d'un signal utilisable. L'extraction de charge est compensée par un appel de charge par le contact substrat qui est, dans le cas généralement utilisé dans l'état de l'art, commun pour l'ensemble des diodes.

Lors de la détection d'un grand flux de photons, chaque diode débite un grand flux de charge, i.e. courant électrique, proportionnel au flux de photon arrivant à proximité de la diode. Les courants de toutes les diodes sont additionnés à travers le substrat jusqu'au contact substrat. En présence d'une résistance électrique dans le substrat, le courant dans celui-ci peut fortement influencer le fonctionnement des diodes.

Cette résistance électrique peut ainsi induire une variation de la polarisation qui altère le fonctionnement des diodes. Dans le cas extrême, elle peut entrainer une annulation du transfert des charges entre les diodes et le circuit de lecture par la suppression de la barrière de potentiel dans les jonctions. Ce phénomène est autant plus important que le nombre de diodes et le flux de photons sur la matrice sont importants.

Cette résistance électrique peut par ailleurs fortement ralentir le transfert des charges dans le circuit de lecture, même en présence d'un flux faible, du fait d'un effet RC collectif.

Par ailleurs, le contrôle de l'état de l'interface entre la couche de passivation 5 et les régions semi-conductrices 1, 2 est crucial pour obtenir une sensibilité maximale. Ceci est dû aux défauts qui peuvent être présents à l'interface, mais aussi à des états dans la passivation qui agissent comme des pièges pour les charges. Les défauts à l'interface peuvent ainsi agir comme des centres de génération/recombinaison des porteurs qui diminuent le signal photonique et augmentent la contribution du courant d'origine thermique ou électrique généré dans le substrat et/ou dans la jonction. Les états pièges dans la passivation sont quant à eux susceptibles de faire varier temporellement la densité de charge locale à proximité de chaque piège. Ces fluctuations peuvent à leur tour générer des fluctuations sur le courant photonique et sur les différents courants d'obscurité.

On cherche donc d'une manière générale à réduire l'effet de résistance série collectif et à stabiliser la performance des diodes afin d'augmenter la sensibilité du photo-détecteur.

On connaît ainsi de la demande de brevet EP 2 806 457 A2 une solution consistant à réaliser un réseau de sur-dopage entre les diodes afin de stabiliser l'interface entre le substrat et la couche de passivation. Cette solution est représentée sur la figure 2. Elle consiste à former des lignes conductrices enterrées 6 qui s'étendent entre les colonnes et entre les lignes de diodes dans la matrice. Ces lignes enterrées 6 sont plus précisément des lignes dopées par implantation ionique avec le même type de dopage que la couche d'absorption 1, et une densité de dopage plus importante.

On connaît aussi des demandes de brevet EP0350351A1 et JPS62119976 A une matrice de photodiodes réalisée en HgCdTe.

On connaît par ailleurs de la demande EP 3 381 057 A1, celle-ci relevant de l'article 54(3) CBE, un dispositif de photo-détection à réseau de diodes où chaque diode du réseau comporte une région d'absorption qui présente une première énergie de bande interdite et une région de collection qui présente un premier type de dopage. Les diodes adjacentes dans le réseau sont séparées par une tranchée comportant des flancs et un fond. Le fond et les flancs d'une tranchée forment une couche de stabilisation qui présente un deuxième type de dopage opposé au premier type de dopage et une énergie de bande interdite supérieure à la première énergie de bande interdite des régions d'absorption.

### EXPOSÉ DE L'INVENTION

L'invention a pour objectif d'améliorer la sensibilité des photo-détecteurs à réseau de diodes. Pour ce faire, elle propose un dispositif de photo-détection comportant un substrat et un réseau de diodes. Le substrat comprend une couche d'absorption et chaque diode comporte dans la couche d'absorption une région de collection qui présente un premier type de dopage. Le dispositif comporte en outre, sous une surface du substrat, un maillage de conduction qui comprend au moins un canal de conduction intercalé entre les régions de collection de deux diodes adjacentes, l'au moins un canal de conduction présentant un deuxième type de dopage opposé au premier type de dopage et une plus grande densité de dopage que la couche d'absorption. La couche d'absorption présente le premier type de dopage.

Certains aspects préférés mais non limitatifs de ce dispositif sont les suivants :
- le maillage de conduction est recouvert d'un maillage métallique présent sur la surface du substrat ;
- la densité de dopage de l'au moins un canal de conduction est issue d'une diffusion de métal dans la couche d'absorption depuis le maillage métallique ;
- il comprend un contact substrat périphérique agencé sur au moins un côté du réseau de diodes ;
- le maillage métallique est en contact électrique avec le contact substrat périphérique ;
- le maillage de conduction présente une pluralité de canaux de conduction agencés de manière à ce qu'on retrouve un canal de conduction intercalé entre les régions de collection de chacune des diodes adjacentes du réseau de diodes ;
- une couche de passivation recouvre le substrat à l'exception de régions de contact d'un plot électriquement conducteur avec une région de collection d'une diode ;
- la couche d'absorption est une couche de CdHgTe ;
- la couche d'absorption présente une densité de dopage inférieure à 10¹⁵ at/cm³;
- la couche d'absorption présente une diminution de gap, graduelle ou soudaine, dans l'épaisseur de la couche d'absorption depuis la surface du substrat qui délimite une région de fort gap à proximité de la surface dans laquelle on retrouve le maillage de conduction et les régions de collection.

L'invention porte également sur un procédé de fabrication d'un dispositif de photodétection comportant un substrat et un réseau de diodes, le substrat comprenant une couche d'absorption et chaque diode comportant dans la couche d'absorption une région de collection qui présente un premier type de dopage. Le procédé comprend une étape de formation, sous une surface du substrat, d'un maillage de conduction qui comprend au moins un canal de conduction intercalé entre les régions de collection de deux diodes adjacentes, l'au moins un canal de conduction présentant un deuxième type de dopage opposé au premier type de dopage et une plus grande densité de dopage que la couche d'absorption. Le procédé comprend par ailleurs un dopage de la couche d'absorption selon le premier type de dopage.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels, outre les figures la, 1b et 2 déjà commentées :
- les figures 3a et 3b sont respectivement une vue de dessus et une vue en coupe le long d'une ligne de diodes d'une matrice de diodes conforme à l'invention ;
- la figure 4 illustre une variante de réalisation de l'invention avec variation de gap dans l'épaisseur de la couche d'absorption ;
- les figures 5a-5f illustrent une réalisation possible d'un procédé de fabrication d'un dispositif de photo-détection conforme à l'invention.

### EXPOSÉ DÉTAILLÉ DE MODES DE RÉALISATION PARTICULIERS

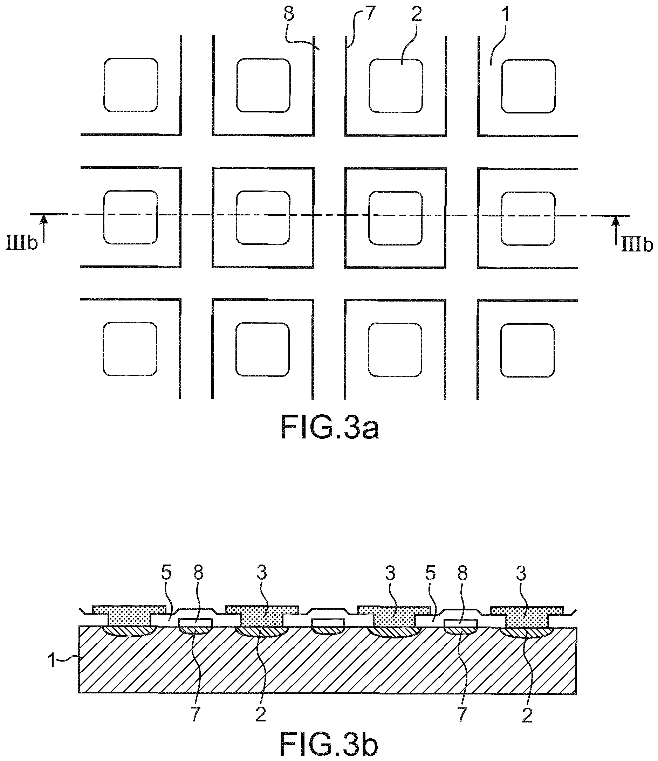

En référence aux figures 3a et 3b, l'invention porte sur un dispositif de photo-détection comportant un substrat et un réseau de diodes. Ces figures 3a et 3b représentent respectivement une vue de dessus et une vue en coupe, selon le plan de coupe référencé IIIb sur la figure la, le long d'une ligne du réseau.

Le substrat comprend une couche d'absorption 1 présentant un premier type de dopage et chaque diode comporte dans la couche d'absorption 1 une région de collection 2 qui présente également le premier type de dopage.

La couche d'absorption est par exemple une couche de CdHgTe. Une telle couche peut notamment être formée par épitaxie sur un substrat de CdZnTe. Sa composition en cadmium peut être comprise entre 20 et 40%. Son épaisseur est de préférence inférieure à 5 µm, par exemple de 3 µm.

Le dopage de la couche d'absorption 1 peut être de type n. Il peut s'agir d'un dopage extrinsèque, par exemple par incorporation d'indium. La densité de dopage de la couche d'absorption est typiquement inférieure à 10¹⁵ at/cm³.

Le dopage de la région de collection 2 est également de type n. Ce dopage peut être extrinsèque, par exemple par incorporation d'indium. La densité de dopage de la région de collection 2 est supérieure à celle de la couche d'absorption. Elle est typiquement comprise entre 10¹⁶ et 10¹⁸ at/cm³.

Bien entendu, l'invention s'étend au cas d'un dopage de la couche d'absorption 1 et de la région de collection 2 de type p.

Le dispositif selon l'invention comprend en outre, sous la surface du substrat au niveau de laquelle sont réalisées les régions de collection (face du substrat opposée à celle recevant le rayonnement électromagnétique), un maillage de conduction comprenant au moins un canal de conduction 7 intercalé entre les régions de collection de deux diodes adjacentes. L'au moins un canal de conduction 7 présente un deuxième type de dopage opposé au premier type de dopage et une plus grande densité de dopage que la couche d'absorption. La densité de dopage de l'au moins un canal de conduction 7 est typiquement comprise entre 10¹⁶ et 10¹⁸ at/cm³.

Un canal de conduction 7 entre les régions de collection de deux diodes adjacentes présente de préférence une largeur (le long d'une ligne du réseau) d'étendue plus importante que le diamètre des régions de collection 2. Le canal de conduction présente typiquement une largeur correspondant à la moitié du pas du pixel (par exemple 7,5 µm pour un pas de 15 µm). Les régions de collection présente quant à elles un diamètre de l'ordre de 1 à 2 µm.

L'épaisseur de la couche d'absorption 1 est de préférence inférieure à la distance séparant une région de collection 2 d'un canal de conduction 7 adjacent. Elle est typiquement inférieure à 3 µm.

L'association de cette épaisseur de la couche d'absorption avec un dopage de la couche d'absorption à un niveau suffisamment faible, typiquement inférieur à 10¹⁵ cm⁻³, conduit à ce que la couche d'absorption est complètement désertée (*depleted* en anglais) dans la profondeur au-dessous du canal de conduction 7 et partiellement désertée dans l'environnement de la région de collection 2 lors de l'application d'une polarisation inverse sur la diode formée par une région de collection 2 et le maillage de conduction 7. La tension de polarisation est liée aux épaisseurs et aux dopages. Elle peut typiquement être de 1V, de préférence de 2V, voire de 3V.

Cette structure présente l'avantage de ne pas être le siège de génération Auger dans la région désertée. En revanche, le courant de génération du courant d'obscurité sur des défauts (génération Schockley-Read-Hall) va augmenter. Cette structure présente également l'avantage de permettre la collection des charges par le champ électrique dans la région désertée, ce qui limite l'étalement de la réponse entre les pixels pour une excitation lumineuse localisée.

Le maillage de conduction est enterré dans le substrat et affleure à la surface du substrat. Différentes topologies de maillage de conduction peuvent être mises en œuvre dans le cadre de l'invention. De préférence, ce maillage de conduction présente au moins un canal de conduction qui s'étend entre deux rangées adjacentes de diodes. En d'autres termes, ce canal s'étend entre deux lignes adjacentes ou deux colonnes adjacentes de diodes.

Le maillage de conduction présente de préférence une pluralité de canaux de conduction qui s'étendent chacun entre deux rangées (lignes ou colonnes) adjacentes de diodes. En particulier, on peut prévoir une pluralité de canaux de conduction agencés de manière à ce qu'on retrouve un canal de conduction intercalé entre les régions de collection de chacune des diodes adjacentes du réseau de diodes. En d'autres termes, et comme représenté sur la figure 3a dans le cas d'un réseau matriciel de diodes, chaque diode est séparée de ses diodes adjacentes par quatre canaux de conduction qui viennent s'entrecroiser.

La densité de dopage de l'au moins un canal de conduction 7 peut être issue d'une implantation d'impuretés, par exemple une implantation d'arsenic, ou bien être issue d'une diffusion de métal dans la couche d'absorption. Le métal est par exemple de l'or ou du cuivre lorsqu'il s'agit de réaliser un dopage de type P+ du maillage de conduction 7. Le métal est par exemple de l'indium lorsqu'il s'agit de réaliser un dopage de type N+ du maillage de conduction 7.

Le métal diffusé vient se placer sur un site de substitution dans le réseau cristallin du semi-conducteur en créant des états donneurs ou accepteurs conduisant au sur-dopage. La diffusion de métal est de préférence réalisée par un traitement thermique.

En plus de stabiliser l'interface entre le semi-conducteur et la couche de passivation de la même façon que dans la demande de brevet EP2806457A2, la formation du maillage de conduction fortement dopé par diffusion de métal permet de réduire la formation de défauts par rapport à une réalisation de la région fortement dopée par implantation ionique telle que proposée dans la demande de brevet EP2806457A2. Cette réduction de défauts conduit à une amélioration de la performance des diodes avec une réduction du courant d'obscurité et du nombre de diodes en défaut de bruit.

La diffusion de métal s'effectue depuis un maillage métallique 8 présent directement sur la surface du substrat, par exemple un maillage d'or, de cuivre ou d'indium. Ce maillage métallique 8 recouvre donc directement et intégralement le maillage de conduction 7. Il est ainsi distribué sur la surface du substrat selon le même motif que le maillage de conduction sur-dopé.

Le maillage métallique 8 forme un contact ohmique avec le substrat dans lequel le courant est directement conduit. Ainsi la présence de ce maillage métallique apporte avantageusement une forte réduction de la résistance d'accès série, et donc des effets de dépolarisation et de RC collectifs.

Lorsque le maillage de conduction est réalisé par implantation d'impuretés, il peut être recouvert d'un maillage métallique présentant le même motif ou bien être recouvert d'un maillage métallique uniquement sur sa périphérie.

Le dispositif selon l'invention comporte par ailleurs un contact substrat périphérique agencé sur au moins un côté du réseau de diodes. Ce contact n'est pas représenté sur les figures 3a et 3b mais est similaire à celui discuté précédemment en liaison avec les figures la et 1b. Un tel contact substrat périphérique permet de réaliser une connexion électrique entre le substrat et le circuit de lecture sur la périphérie du réseau de diodes libérant ainsi de la place entre les diodes, et permettant avantageusement de réaliser un réseau de diodes avec un faible pas entre les diodes.

Le maillage de conduction 7 est de préférence en contact électrique avec le contact substrat périphérique, notamment par l'intermédiaire du maillage métallique 8.

Le dispositif selon l'invention comporte par ailleurs une couche de passivation 5 qui recouvre le substrat à l'exception de régions de contact d'un plot électriquement conducteur 3 avec une région de collection 2 d'une diode, et le cas échéant d'une région de contact périphérique d'un plot électriquement conducteur avec le substrat.

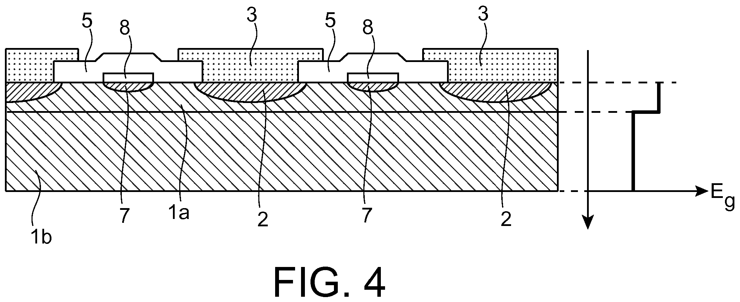

Dans une variante de réalisation représentée sur la figure 4, la couche d'absorption présente une diminution de gap Eg (énergie de bande interdite) depuis la surface du substrat dans l'épaisseur de la couche d'absorption, cette diminution intervenant globalement à l'interface où sont localisés les régions de collections et le maillage de conduction. Avec une couche d'absorption en CdHgTe par exemple, cette variation de gap peut être obtenue en faisant varier la teneur en cadmium. Cette variation du gap permet de passiver la surface (face du substrat opposée à celle recevant le rayonnement électromagnétique), de réduire la génération du courant d'obscurité tunnel induite par la concentration du champ électrique au niveau du maillage métallique, et la génération Auger induite par le fort dopage dans les régions de collection 2 et le maillage métallique 7.

Comme représenté sur la figure 4, la variation de gap est soudaine et intervient à une profondeur donnée dans l'épaisseur de la couche d'absorption depuis la surface du substrat. La couche d'absorption est alors constituée de deux régions la, 1b avec des valeurs de gap d'énergie différentes. On retrouve dans la région la de fort gap les régions de collection 2 et le maillage de conduction 7. La région la présente ainsi une épaisseur comprise entre 0,5µm et 1µm. La région 1b sous-jacente à la région de fort gap la est caractérisée par un gap plus faible. En variante, la variation de gap peut être graduelle.

L'invention n'est pas limitée au dispositif de photo-détection précédemment décrit, mais s'étend également à un procédé de fabrication d'un dispositif de photo-détection comportant un substrat et un réseau de diodes, le substrat comprenant une couche d'absorption 1 et chaque diode comportant dans la couche d'absorption 1 une région de collection 2 qui présente un premier type de dopage. Le procédé comprend une étape de formation, sous la surface du substrat, d'un maillage de conduction 7 comprenant au moins un canal de conduction intercalé entre les régions de collection de deux diodes adjacentes, l'au moins un canal de conduction présentant un deuxième type de dopage opposé au premier type et une plus grande densité de dopage que la couche d'absorption. Dans le cadre de l'invention, la couche d'absorption présente le premier type de dopage. On peut par ailleurs procéder à la formation d'un maillage métallique en surface du substrat, l'étape de formation du maillage de conduction étant alors réalisée par diffusion de métal depuis le maillage métallique en surface du substrat.

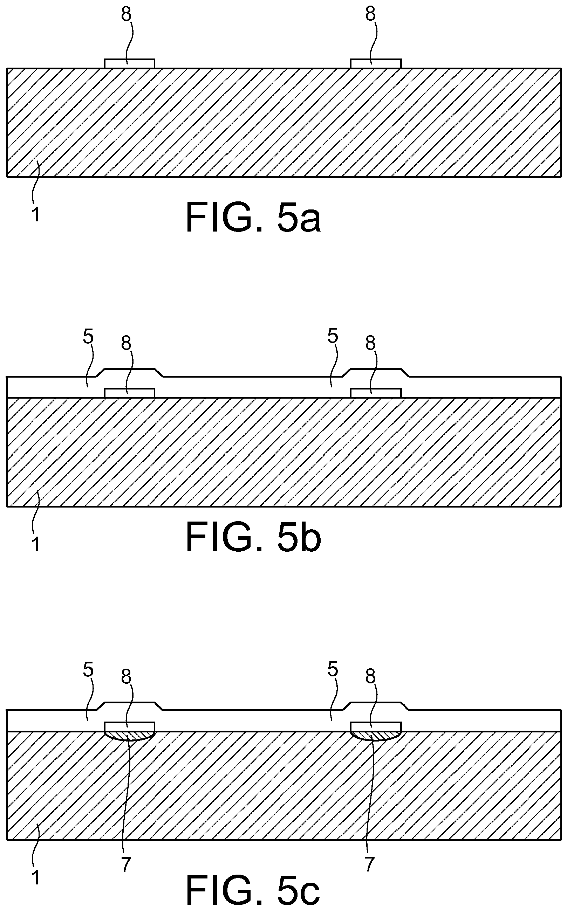

Les figures 5a-5f illustrent un exemple de réalisation d'un tel procédé qui débute par une étape de fourniture d'un substrat portant la couche d'absorption 1. Suite à une préparation de surface du substrat, on procède comme représenté sur la figure 5a au dépôt du maillage métallique 8 sur la surface du substrat. Le maillage métallique comprend par exemple plusieurs lignes présentant une largeur de 1 µm et une épaisseur de 500 nm. La figure 5b illustre le dépôt d'une couche de passivation 5 sur le substrat et le maillage métallique. On procède ensuite à un recuit de stabilisation de l'interface entre le substrat et la couche de passivation. Ce recuit permet la diffusion de métal du maillage métallique en direction du substrat, résultant comme représenté sur la figure 5c, en la formation du maillage de conduction 7 dans le substrat directement en dessous du maillage métallique 8 en surface du substrat. Lorsque la couche de passivation est déposée avant la diffusion du métal, un simple recuit sous vide peut être utilisé. La couche de passivation peut être cependant déposée après, un recuit sous pression de vapeur saturante de Hg pouvant alors être mis en œuvre.

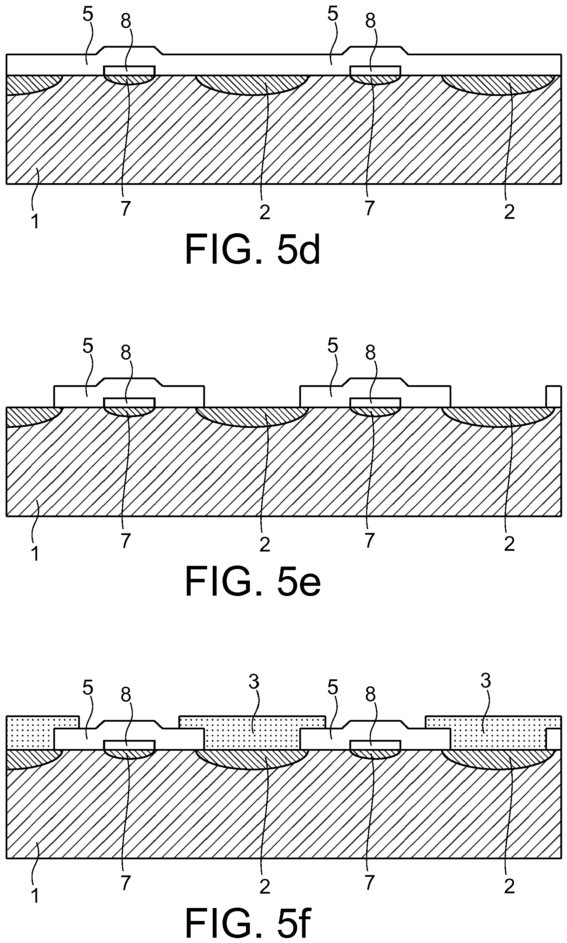

En référence à la figure 5d, on procède ensuite à la formation des régions de collection 2 au moyen d'une implantation ionique au travers un masque approprié. Le diamètre de chaque région de collection est par exemple compris entre 5 et 20 µm, et ces régions sont espacées d'un pas de pixel par exemple compris entre 5 et 30 µm.

On procède ensuite comme représenté à la figure 5e à l'ouverture de la couche de passivation 5 au niveau de chaque pixel, ainsi qu'en périphérie du réseau pour la formation ultérieure du contact substrat.

On procède ensuite comme représenté en figure 5f au dépôt d'une couche de métal et sa gravure au niveau de chaque pixel et à la périphérie pour former les contacts diode 3 et le contact substrat. L'épaisseur de ces contacts est typiquement inférieure à 1 µm.

L'invention trouve avantageusement application pour l'imagerie infrarouge, et en particulier pour l'imagerie à haute température de fonctionnement, où elle permet de réduire le courant d'obscurité induit par la suppression Auger, pour l'imagerie à très faible pas où elle permet de stabiliser l'interface entre les diodes et d'augmenter la fonction de transfert de modulation du photo-détecteur, pour l'imagerie à grand format où elle permet de réduire l'effet de dépolarisation en cas de fort flux, pour l'imagerie active où elle permet de réduire l'effet de la dépolarisation et le ralentissement causé par l'effet RC collectif.

## Revendications

1. Dispositif de photo-détection comportant un substrat et un réseau de diodes, le substrat comprenant une couche d'absorption (1) et chaque diode comportant dans la couche d'absorption une région de collection (2) qui présente un premier type de dopage, le dispositif comportant, sous une surface du substrat, un maillage de conduction (7) comprenant au moins un canal de conduction intercalé entre les régions de collection (2) de deux diodes adjacentes, l'au moins un canal de conduction (7) présentant un deuxième type de dopage opposé au premier type de dopage et une plus grande densité de dopage que la couche d'absorption, **caractérisé en ce que** la couche d'absorption présente le premier type de dopage.

2. Dispositif selon la revendication 1, dans lequel le maillage de conduction (7) est recouvert d'un maillage métallique (8) présent sur la surface du substrat.

3. Dispositif selon la revendication 2, dans lequel la densité de dopage de l'au moins un canal de conduction (7) est issue d'une diffusion de métal dans la couche d'absorption depuis le maillage métallique (8).

4. Dispositif selon l'une des revendications 1 à 3, comprenant un contact substrat (4) périphérique agencé sur au moins un côté du réseau de diodes.

5. Dispositif selon la revendication 4, dans lequel le maillage métallique (8) est en contact électrique avec le contact substrat périphérique.

6. Dispositif selon l'une des revendications 1 à 5, dans lequel le maillage de conduction (7) présente au moins un canal de conduction s'étendant entre deux rangées adjacentes de diodes.

7. Dispositif selon la revendication 6, dans lequel le maillage de conduction (7) présente une pluralité de canaux de conduction agencés de manière à ce qu'on retrouve un canal de conduction intercalé entre les régions de collection de chacune des diodes adjacentes du réseau de diodes.

8. Dispositif selon l'une des revendications 1 à 7, dans lequel une couche de passivation (3) recouvre le substrat à l'exception de régions de contact d'un plot électriquement conducteur (3) avec une région de collection (2) d'une diode.

9. Dispositif selon l'une des revendications 1 à 8, dans lequel la couche d'absorption (1) est une couche de CdHgTe.

10. Dispositif selon l'une des revendications 1 à 9, dans lequel la couche d'absorption (1) présente une densité de dopage inférieure à 10¹⁵ at/cm³.

11. Dispositif selon l'une des revendications 1 à 9, dans lequel la couche d'absorption (1) présente une diminution de gap, graduelle ou soudaine, dans l'épaisseur de la couche d'absorption depuis la surface du substrat qui délimite une région (la) de fort gap à proximité de la surface dans laquelle on retrouve le maillage de conduction (7) et les régions de collection (2).

12. Procédé de fabrication d'un dispositif de photodétection comportant un substrat et un réseau de diodes, le substrat comprenant une couche d'absorption (1) et chaque diode comportant dans la couche d'absorption (1) une région de collection (2) qui présente un premier type de dopage,
le procédé comprenant une étape de formation, sous une surface du substrat, d'un maillage de conduction (7) comprenant au moins un canal de conduction intercalé entre les régions de collection de deux diodes adjacentes, l'au moins un canal de conduction présentant un deuxième type de dopage opposé au premier type de dopage et une plus grande densité de dopage que la couche d'absorption,
le procédé étant **caractérisé en ce qu'**il comprend un dopage de la couche d'absorption selon le premier type de dopage.

13. Procédé selon la revendication 12, comprenant en outre la formation d'un maillage métallique (8) incluant au moins une ligne métallique en surface du substrat et dans lequel dans l'étape de formation du maillage de conduction (7) l'au moins un canal de conduction (7) est réalisé par diffusion de métal dans la couche d'absorption depuis le maillage métallique (8).

## Patentansprüche

1. Photodetektionsvorrichtung mit einem Substrat und einem Array von Dioden, wobei das Substrat eine Absorptionsschicht (1) enthält und jede Diode in der Absorptionsschicht einen Sammelbereich (2) enthält, der einen ersten Dotierungstyp aufweist, wobei die Vorrichtung unter einer Oberfläche des Substrats ein Leitungsgitter (7) enthält, das zumindest einen Leitungskanal aufweist, der zwischen den Sammelbereichen (2) zweier benachbarter Dioden angeordnet ist, wobei der zumindest eine Leitungskanal (7) einen zweiten Dotierungstyp, der dem ersten Dotierungstyp entgegengesetzt ist, und eine höhere Dotierungsdichte als die Absorptionsschicht aufweist, **dadurch gekennzeichnet, dass** die Absorptionsschicht den ersten Dotierungstyp aufweist.

2. Vorrichtung nach Anspruch 1, wobei das Leitungsgitter (7) mit einem Metallgitter (8) bedeckt ist, das an der Oberfläche des Substrats vorliegt.

3. Vorrichtung nach Anspruch 2, wobei sich die Dotierungsdichte des zumindest einen Leitungskanals (7) aus einem Diffundieren von Metall aus dem Metallgitter (8) in die Absorptionsschicht ergibt.

4. Vorrichtung nach einem der Ansprüche 1 bis 3, enthaltend einen umlaufenden Substratkontakt (4), der auf zumindest einer Seite des Diodenarrays angeordnet ist.

5. Vorrichtung nach Anspruch 4, wobei das Metallgitter (8) in elektrischem Kontakt mit dem umlaufenden Substratkontakt steht.

6. Vorrichtung nach einem der Ansprüche 1 bis 5, wobei das Leitungsgitter (7) zumindest einen Leitungskanal aufweist, der sich zwischen zwei benachbarten Diodenreihen erstreckt.

7. Vorrichtung nach Anspruch 6, wobei das Leitungsgitter (7) eine Vielzahl von Leitungskanälen aufweist, die so angeordnet sind, dass zwischen den Sammelbereichen jeder der benachbarten Dioden des Diodenarrays ein Leitungskanal vorhanden ist.

8. Vorrichtung nach einem der Ansprüche 1 bis 7, wobei eine Passivierungsschicht (3) das Substrat mit Ausnahme von Kontaktbereichen eines elektrisch leitenden Pads (3) mit einem Sammelbereich (2) einer Diode bedeckt.

9. Vorrichtung nach einem der Ansprüche 1 bis 8, wobei die Absorptionsschicht (1) eine CdHgTe-Schicht ist.

10. Vorrichtung nach einem der Ansprüche 1 bis 9, wobei die Absorptionsschicht (1) eine Dotierungsdichte von weniger als 10¹⁵ at/cm³ aufweist.

11. Vorrichtung nach einem der Ansprüche 1 bis 9, wobei die Absorptionsschicht (1) eine stufenartige oder plötzliche Spaltverminderung in der Dicke der Absorptionsschicht von der Oberfläche des Substrats ausgehend aufweist, die einen Bereich (1a) mit hohem Spalt nahe der Oberfläche abgrenzt, in dem sich das Leitungsgitter (7) und die Sammelbereiche (2) befinden.

12. Verfahren zur Herstellung einer Photodetektionsvorrichtung, die ein Substrat und ein Array von Dioden enthält, wobei das Substrat eine Absorptionsschicht (1) enthält und jede Diode in der Absorptionsschicht (1) einen Sammelbereich (2) enthält, der einen ersten Dotierungstyp aufweist, wobei das Verfahren einen Schritt des Ausbildens eines Leitungsgitters (7) unter einer Oberfläche des Substrats umfasst, das zumindest einen Leitungskanal aufweist, der zwischen den Sammelbereichen von zwei benachbarten Dioden angeordnet ist, wobei der zumindest eine Leitungskanal einen zweiten Dotierungstyp aufweist, der dem ersten Dotierungstyp entgegengesetzt ist, und eine höhere Dotierungsdichte als die Absorptionsschicht aufweist,
wobei das Verfahren **dadurch gekennzeichnet ist, dass** es eine Dotierung der Absorptionsschicht mit dem ersten Dotierungstyp umfasst.

13. Verfahren nach Anspruch 12, ferner umfassend das Ausbilden eines Metallgitters (8), das zumindest eine Metallleitung an der Oberfläche des Substrats enthält, wobei bei dem Schritt des Ausbildens des Leitungsgitters (7) der zumindest eine Leitungskanal (7) durch Diffundieren von Metall aus dem Metallgitter (8) in die Absorptionsschicht gebildet wird.

## Claims

1. A photodetection device comprising a substrate and a network of diodes, the substrate comprising an absorption layer (1) and each diode comprising a collection region (2) with a first type of doping in the absorption layer, the photodetection device further comprising a conduction mesh (7) under the surface of the substrate, the conduction mesh comprising at least one conduction channel inserted between the collection regions (2) of two adjacent diodes, the at least one conduction channel having a second type of doping opposite the first type of doping and a higher doping density than the absorption layer, wherein the absorption layer has the first type of doping.

2. The photodetection device according to claim 1, wherein the conduction mesh (7) is covered by a metal mesh (8) present on the surface of the substrate.

3. The photodetection device according to claim 2, wherein the doping density of the at least one conduction channel (7) is derived from metal diffusion in the absorption layer from the metal mesh (8).

4. The photodetection device according to any of the claims 1 to 3, further comprising a peripheral substrate contact (4) on at least one side of the diodes network.

5. The photodetection device according to claim 4, wherein the metal mesh (8) is in electrical contact with the peripheral substrate contact (4).

6. The photodetection device according to any of the claims 1 to 5, wherein the conduction mesh (7) has at least one conduction channel extending between two adjacent rows of diodes.

7. The photodetection device according to claim 6, wherein the conduction mesh (7) has a plurality of conduction channels arranged such that a there is a conduction channel inserted between the collection regions of all adjacent diodes in the diodes network.

8. The photodetection device according to any of the claims 1 to 7, further comprising a passivation layer (3) which covers the substrate except at contact regions of an electrically conducting pad with a collection region (2) of a diode.

9. The photodetection device according to any of the claims 1 to 8, wherein the absorption layer (1) is a CdHgTe layer.

10. The photodetection device according to any of the claims 1 to 9, wherein the doping density of the absorption layer (1) is less than 10¹⁵ at/cm³.

11. The photodetection device according to any of the claims 1 to 9, wherein the absorption layer (1) includes a gradual or sudden gap reduction within the thickness of the absorption layer from the surface of the substrate, said gradual or sudden gap reduction delimiting a large gap region (1a) near the surface in which the conduction mesh (7) and collection regions (2) are located.

12. A method of making a photodetection device comprising a substrate and a diodes network, the substrate comprising an absorption layer (1) and each diode comprising a collection region (2) in the absorption layer (1) with a first type of doping, the method including a step of forming a conduction mesh (7) under the surface of the substrate, the conduction mesh comprising at least one conduction channel inserted between the collection regions of two adjacent diodes, the at least one conduction channel having a second doping type opposite the first doping type and a higher doping density than the absorption layer,
the method comprising a step of doping the absorption layer according to the first type of doping.

13. The method according to claim 12, also including the formation of a metal mesh (8) including at least one metallic line on the surface of the substrate and in which the step of forming the conduction mesh (8) is done by metal diffusion from the
metal mesh (7).
